# FASCICULE DE BREVET EUROPEEN

(11) **EP 1 744 603 B1**
(45) Date de publication et mention de la délivrance du brevet: **19.11.2008**
(21) Numéro de dépôt: 06291098.9
(22) Date de dépôt: 03.07.2006
(51) Int. Cl.: H05B 41/288, H01L 25/065, H01J 61/16, B60Q 1/02

(54) **Dispositif d'éclairage et/ou de signalisation pour véhicule, associé à une électronique de haut niveau d'intégration.**
Signal- oder Beleuchtungseinrichtung für ein Kraftfahrzeug, mit einer Elektronik von hoher Integrationskomplexität
Signalling or lighting device for a motor vehicle, associated with an electronics of a large integration level

(30) Priorité: 08.07.2005 FR 0507308
(43) Date de publication de la demande: 17.01.2007
(73) Titulaire: VALEO VISION, 93012 Bobigny Cedex (FR)
(72) Inventeur: Nicolai, Jean-Marc, 94200 Courbevoie (FR)

(56) Documents cités:
- EP-A- 0 746 186
- US-A1- 2003 153 122
- US-B1- 6 351 074
- S. HAQUE, K.XING, R.-L. LIN, C.T.A. SUCHICITAL, G.-Q. LU, D.J. NELSON, D. BOROJEVIC, F.C. LEE: "An Innovative Technique for Packaging Power Electronic Building Blocks Using Metal Posts Interconnected Parallel Plate Structures" IEEE TRANSACTIONS ON ADVANCED PACKAGING, vol. 22, no. 2, mai 1999 (1999-05), pages 136-144, XP011002144

## Description

L'invention concerne de manière générale des dispositifs d'éclairage et/ou signalisation, tels que projecteurs, destinés à être montés dans des véhicules automobiles.

Plus particulièrement, l'invention concerne un dispositif d'éclairage et/ou signalisation pour véhicule comprenant une source de lumière et des moyens électroniques d'alimentation et de commande. L'invention concerne également une source de lumière apte à être montée dans un tel dispositif.

L'évolution technique actuelle dans le domaine de l'automobile tend vers davantage d'intégration de composants et de circuits électroniques dans les véhicules.

En particulier, pour ce qui concerne les projecteurs d'éclairage et les feux de signalisation, la part de l'électronique dans la composition des produits a très fortement augmentée ces dernières années, notamment avec l'introduction des lampes à décharge dans les projecteurs et des diodes électroluminescentes dans les feux de signalisation.

Dans les années qui viennent, cette évolution ne peut que se poursuivre dans les systèmes d'éclairage et/ou signalisation compte tenu de l'introduction progressive des fonctions avancées de type AFS, parmi lesquelles on trouve notamment:
- une fonction dite DBL (« Dynamic Bending Light » en anglais pour lumière virage mobile) : cette fonction permet d'orienter un faisceau lumineux produit par une source lumineuse, par exemple en déplaçant un réflecteur par rapport à la source de lumière à laquelle il est associé, de telle sorte que lorsque le véhicule aborde un virage, la route soit éclairée de façon optimale ;
- une fonction dite FBL (« Fixed Bending Light » en anglais pour lumière virage fixe): cette fonction a pour vocation d'éclairer progressivement le bas-côté de la route lorsque le véhicule effectue un virage ; à cet effet, on prévoit une source lumineuse supplémentaire qui vient compléter progressivement les feux de croisement ou de route lors de la négociation d'un virage ;
- une fonction dite DRL (« Day Running Light » en anglais): cette fonction, couramment appelée feu de circulation diurne, assure l'allumage permanent de projecteurs du dispositif projecteur, notamment pour signaler aux piétons la présence du véhicule en circulation et ainsi éviter les chocs piétons ;
- une fonction dite « Town Light » en anglais, pour feu de ville. Cette fonction assure l'élargissement d'un faisceau de type feu de croisement tout en diminuant légèrement sa portée ;
- une fonction dite « Motorway Light » en anglais, pour feu d'autoroute. Cette fonction assure une augmentation de la portée d'un feu de croisement ;
- une fonction dite AWL (« Adverse Weather Light » en anglais, pour feu de mauvais temps). Cette fonction assure une modification d'un faisceau de feu de croisement de telle sorte que le conducteur n'est pas ébloui par un reflet de son propre projecteur ;
- une fonction dite « Overhead Light » en anglais, pour feu surélevé. Cette fonction assure une modification d'un faisceau de feu de croisement de telle sorte que des portiques situés en hauteur sont éclairés de façon satisfaisante au moyen des feux de croisement.

La part croissante de l'électronique dans les systèmes d'éclairage et/ou signalisation oriente les efforts actuels de recherche et développement vers une intégration de plus en plus poussée des circuits électroniques et notamment de l'intégration sur un même substrat de composants de puissance et de composants dédiés à la commande. Outre le gain de compacité, l'intégration des composants électroniques est de nature à générer les différents effets avantageux connus tels que de meilleures performances et fiabilité et des coûts moindres.

L'intégration des composants de puissance tels que des transistors IGBT (pour « Insulated Gate Bipolar Transistor » en anglais) ou MOS pose des difficultés particulières liées à la gestion des contraintes thermiques des circuits.

Il est connu de l'entité inventive un ballast électronique pour l'alimentation d'une lampe à décharge de type xénon comprenant sur un même substrat quatre transistors de puissance IGBT et différents autres composants de types analogique et numérique.

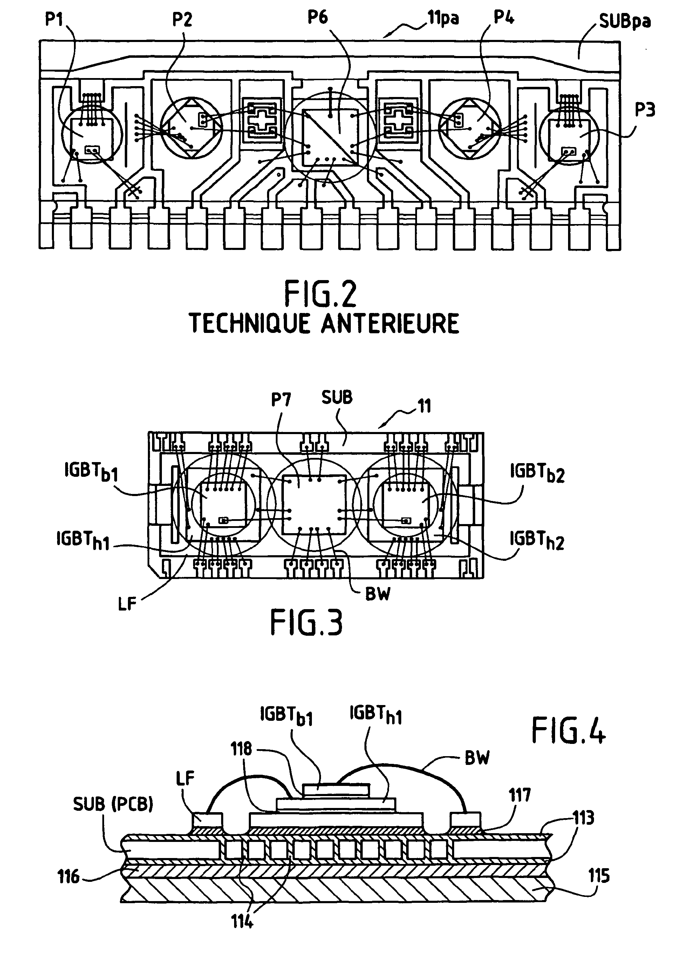

Ce ballast selon la technique antérieure est montré à la Fig.2 et est désigné 11ₚₐ ci-dessous.

La Fig.2 montre en vue de dessus l'implantation des différentes puces du ballast 11ₚₐ sur un substrat SUBₚₐ de type circuit imprimé. Les puces désignées P1, P2, P3 et P4 sont celles de quatre transistors de puissance IGBT formant un pont de commutation d'un convertisseur de tension de type continu-alternatif (DC/AC) qui est inclus dans le ballast 11ₚₐ. Les composants repérés globalement P6 sont ceux d'un convertisseur de tension de type continu-continu (DC/DC) et d'un circuit de commande inclus également dans le ballast 11ₚₐ.

Des techniques microélectroniques connues sont utilisées afin d'implanter les composants électroniques sur le substrat SUBₚₐ et d'établir entre ceux-ci les liaisons électriques appropriées. Bien que ce ballast de la technique antérieure présente un niveau d'intégration déjà relativement élevé et satisfasse aux différentes contraintes, notamment de température élevée (température supérieure à 150°C), imposées à ce type de circuit dans un projecteur d'éclairage, il est souhaitable aujourd'hui de proposer des nouvelles solutions autorisant des avancées supplémentaires dans l'intégration des circuits électroniques dédiés aux systèmes d'éclairage et/ou signalisation.

On connaît dans l'état de la technique notamment les documents EP 0 746 186 et US 2003/153122 ,ainsi que l'article "An Innovative Technique for Packaging Power Electronic Building Blocks Using Metal Posts Interconnected Parallel Plate Structures", de S. HAQUE, K.XING, R.-L. LIN, C.T.A. SUCHICITAL, G.-Q. LU, D.J. NELSON, D. BOROJEVIC et F.C. LEE, paru dans "IEEE TRANSACTIONS ON ADVANCED PACKAGING", VOL. 22, NO 2, mai 1999, pages 136-144.

Selon un premier aspect, la présente invention fournit un dispositif d'éclairage et/ou signalisation pour véhicule automobile comprenant une source de lumière et des moyens électroniques d'alimentation et de commande, les moyens électroniques comprenant au moins un circuit comportant au moins un empilage de puces formé d'au moins deux composants, caractérisé en ce que les composants sont des composants de puissance, en ce que une face inférieure d'un composant de puissance est fixée sur une face supérieure d'un autre composant de puissance, et en ce que le circuit comprend un substrat de type circuit imprimé haute température, de type capton, de type céramique ou de type grille de connexion.

Corrélativement, l'invention concerne également un système d'éclairage et/ou signalisation pour véhicule automobile caractérisé en ce que il comprend au moins deux dispositifs d'éclairage et/ou signalisation selon l'une au moins des revendications précédentes.

Selon une forme de réalisation particulière, la source de lumière comporte une lampe à décharge et ledit circuit est un convertisseur de type continu-alternatif alimentant la lampe à décharge. De préférence, la lampe à décharge est de type xénon.

Selon encore d'autres caractéristiques particulières :
- Le circuit comportant au moins un empilage de puces est compris dans un ballast électronique dudit dispositif.
- Le circuit comportant au moins un empilage de puces est compris dans un module électronique associé à la lampe à décharge et formant avec celle-ci un ensemble compact.
- Le circuit comporte un pont de commutation à quatre transistors et deux empilages de puces formés chacun avec deux transistors d'une même branche du pont de commutation. De préférence, les transistors sont de type IGBT ou MOS.
- Le substrat comprend au moins un via thermique au niveau d'au moins un empilage de puces.
- Le circuit comprend un drain thermique contre lequel vient en contact thermique une face du substrat. De préférence, le drain thermique est formé par un boîtier contenant le circuit.
- Le substrat et le drain thermique sont fixés ensemble au moyen d'un adhésif et/ou d'une feuille de préimprégné.
- Le circuit comprend également des moyens de connexion électrique comportant une grille de connexion et/ou des fils conducteurs soudés.

Selon une autre caractéristique, l'empilage de puces comprend également une puce de circuit de commande empilée avec les composants de puissance.

Selon la forme de réalisation de l'invention, cette puce de circuit de commande pourra prendre différentes formes et remplir différentes fonctions. Ainsi, dans le cas où l'empilage de puces est implanté dans un ballast de lampe à décharge, la puce de circuit de commande construite autour d'un microcontrôleur ou microprocesseur assurera par exemple la gestion de commande des convertisseurs continu-continu et continu-alternatif du ballast. Dans le cas où l'empilage de puces est implanté dans un module électronique associé à une lampe à décharge et formant avec celle-ci un ensemble compact, la puce de circuit de commande assurera par exemple l'ensemble ou certaines des fonctions de gestion de la lampe telles que des fonctions d'intelligence de type HDL.

Selon d'autres aspects, l'invention concernent également une source de lumière apte à être montée dans un dispositif ou système d'éclairage et/ou signalisation selon l'invention, et un véhicule automobile équipé d'au moins une source de lumière ou un dispositif d'éclairage et/ou signalisation selon l'invention.

D'autres aspects et avantages de la présente l'invention apparaîtront plus clairement à la lecture de la description de formes de réalisation particulières qui vont suivre, cette description étant donnée à titre d'exemple non limitatif et faite en référence aux dessins annexés, dans lesquels :
la Fig.1 montre une première forme de réalisation particulière d'un projecteur selon l'invention dans laquelle des empilages de puces sont implantés dans un ballast du projecteur;
la Fig.2 montre en vue de dessus l'implantation de différentes puces dans un ballast selon la technique antérieure;
la Fig.3 montre en vue de dessus l'implantation d'empilages de puces dans un ballast compris dans le projecteur de la Fig.1;
la Fig.4 est en vue partielle en coupe du ballast de la Fig.3; et
la Fig.5 montre une seconde forme de réalisation particulière d'un projecteur selon l'invention dans laquelle des empilages de puces sont implantés dans une source de lumière du projecteur.

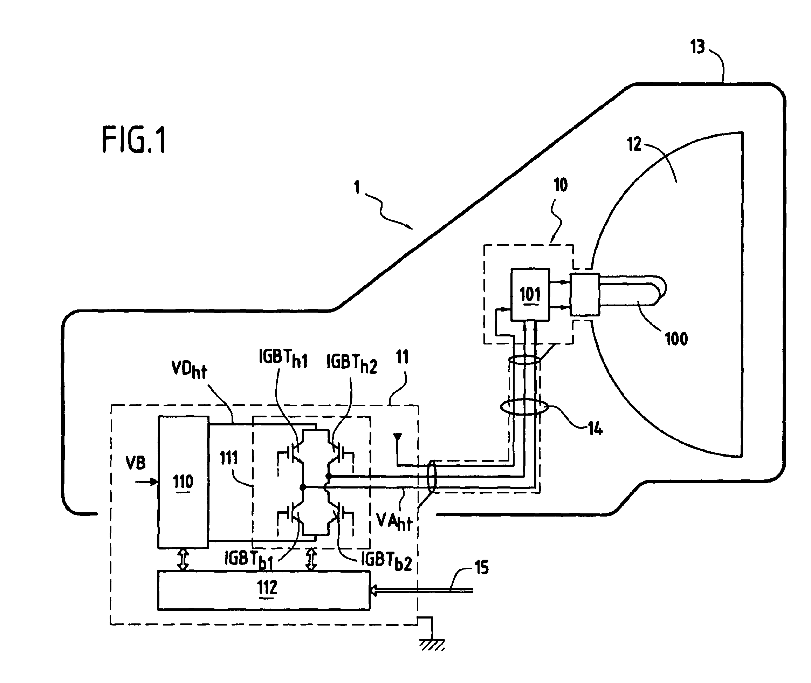

En référence à la Fig.1, il est maintenant décrit une première forme de réalisation particulière, désignée globalement 1, d'un dispositif d'éclairage et/ou signalisation tel que projecteur selon l'invention. Dans cette forme de réalisation particulière, la source de lumière est une lampe à décharge de type xénon.

Comme montré à la Fig.1, le projecteur 1 comprend essentiellement une source de lumière 10, un module électronique d'alimentation de lampe 11, un réflecteur 12 et un boîtier 13 auquel sont assemblés les éléments ci-dessus.

Bien entendu, le boîtier 13.est associé à une glace (non représentée) autorisant une émission vers l'extérieur du faisceau d'éclairage produit par le projecteur 1.

Plus précisément, la source de lumière 10 comporte une lampe à décharge 100 de type xénon et un module d'amorçage haute tension (HT) 101.

La lampe à décharge 100 et le module d'amorçage HT 101 forment un ensemble compact qui peut être désolidarisé ou pas en deux parties selon le standard utilisé, par exemple D1 ou D2.

Le module d'alimentation de lampe 11 est un dispositif, désigné habituellement « ballast », qui fournit à partir d'une tension continue de batterie VB du véhicule des tensions élevées qui sont adaptées au type de lampe à décharge utilisée.

Comme montré à la Fig.1, le ballast 11 comprend essentiellement un convertisseur de tension 110 de type continu-continu (DC/DC), un convertisseur de tension 111 de type continu-alternatif (DC/AC) et un module de commande 112.

Le convertisseur DC/DC 110 reçoit en entrée la tension continue de batterie VB et fournit en sortie une haute tension continue VDₕₜ.

Le convertisseur DC/AC 111 reçoit la haute tension continue VDₕₜ et délivre une haute tension alternative VAₕₜ qui est fournie, à travers un câble blindé 14, au module d'amorçage HT 101.

Le module de commande 112 est par exemple de type à microprocesseur et commande une alimentation régulée de la source de lumière 10 par un pilotage adapté des convertisseurs 110 et 111. De manière classique, des boucles de contre-réaction peuvent être prévues pour réguler en courant et en tension l'alimentation fournie à la source de lumière 10.

Dans cette forme de réalisation particulière, le module de commande 112 est relié à une unité de commande électronique (non représentée) à travers une liaison de communication 15 par exemple de type LIN ou CAN. Cette unité de commande électronique, selon la solution implantée dans le véhicule, est par exemple une unité dédiée à la commande de l'éclairage/signalisation ou une unité centrale du véhicule. Le module de commande 112 reçoit ainsi des commandes telles qu'une commande de marche/arrêt et des commandes de modes d'éclairage correspondant à différents modes d'éclairage possibles. Ces différents modes d'éclairage sont par exemple ceux préconisés dans les systèmes de type AFS (pour « Advanced Front lighting System » ou « Adaptive Front lighting System » en anglais).

Comme montré de manière schématique à la Fig.1, le convertisseur AC/DC 111 comporte un pont de commutation haute tension comprenant 4 transistors de puissance de type IGBT, désignés IGBTₕ₁, IGBTₕ₂, IGBT_{b1} et IGBT_{b2}. De manière connue dans ce type de pont, le pont est formé de 2 branches symétriques, à savoir, la branche IGBTₕ₁, IGBT_{b1} et la branche IGBTₕ₂, IGBT_{b2}, et est commandé en commutation (conduction ou blocage du transistor) par des signaux de commande de commutation fournis par le module de commande 112. Selon une variante, les quatre transistors de puissance sont de type MOS.

Conformément à l'invention, il est fait appel à une technique d'empilage de puces pour la réalisation du circuit électronique du ballast 11.

Cette technique de réalisation du ballast 11 selon l'invention est maintenant décrite en référence aux Figs.3 et 4.

Comme montré plus particulièrement à la Fig.3, les transistors IGBT_{b1} et IGBT_{b2} sont empilés sur les transistors IGBTₕ₁ et IGBTₕ₂, respectivement.

Les empilages IGBT_{b1}, IGBTₕ₁ et IGBT_{b2}, IGBTₕ₂ sont implantés sur le substrat SUB de part et d'autre d'une zone centrale dans laquelle est implantée une puce P7. Dans la puce P7 sont localisés les autres blocs fonctionnels du ballast 11 décrit en référence à la Fig.1, à savoir, notamment le convertisseur DC/DC 110 et le module de commande 112.

Une grille de connexion électrique de type « Lead Frame » LF et un certain nombre de fils conducteurs soudés BW sont également visibles à la Fig.3.

On constatera ici la compacité accrue autorisée par l'invention, et cela par une simple comparaison des vues de dessus des Figs.2 et 3 qui ont été réalisées avec des échelles sensiblement égales.

La Fig.4 montre des détails de réalisation du ballast 11 selon l'invention. La coupe montrée à la Fig.4 est située au niveau de l'empilage IGBT_{b1}, IGBTₕ₁.

Dans cette forme de réalisation particulière, le ballast 11 comprend, en tant que substrat SUB, une carte de circuit imprimé PCB servant de support pour l'implantation des puces. La carte PCB est réalisée par exemple à partir d'un circuit imprimé haute température de type FR4 ou FR5, ou en capton pour une meilleure conduction thermique.

Bien étendu, d'autres standards connus de l'homme du métier sont utilisables pour la carte PCB et leur choix dépendra essentiellement de l'application dans laquelle sera mise en oeuvre l'invention. De plus, en variante, le substrat SUB peut être formé à partir d'une plaquette en céramique ou bien les composants électroniques peuvent être montés directement sur une grille de connexion assurant alors la fonction du substrat SUB (technologie dite «lead frame»).

A la Fig.4, la carte PCB est de type double face et comprend des parties conductrices en cuivre 113 sur des parties superficielles.

Un certain nombre de vias thermiques 114 sont aménagés dans la carte PCB. Les vias thermiques 114 sont ici localisés au niveau des composants de puissance IGBT_{b1}, IGBTₕ₁ et IGBT_{b2}, IGBTₕ₂ et facilitent une évacuation de la chaleur vers un drain thermique 115.

Dans cette forme de réalisation particulière, le drain thermique 115 est constitué par un boîtier en aluminium du ballast 11 dans lequel est logé le circuit électronique.

Un adhésif 116 est employé ici pour fixer la carte PCB, au niveau d'une première face en cuivre 113, sur une paroi de fond du boîtier 115. Dans d'autres formes de réalisation, la carte PCB est assemblée sur le boîtier 115 à travers une interface thermique ou est assemblée à chaud à travers une feuille de préimprégné (« prepeg » en anglais).

Une pâte à brasser 117, déposée par exemple par sérigraphie, établit après chauffage une liaison rigide conductrice entre des pistes conductrices d'une seconde face de la carte PCB et la grille de connexion LF.

Conformément à l'invention, les empilages de puces IGBT_{b1}, IGBTₕ₁ et IGBT_{b2}, IGBTₕ₂ sont ensuite formés par exemple à l'aide de la technique dite « COB » (pour « Chip On Board » en anglais) ou « circuit intégré sur plaquette ».

Un adhésif 118 est utilisé pour fixer une face inférieure du transistor IGBTₕ₁, IGBTₕ₂ sur une partie correspondante de la grille de connexion LF et pour fixer une face inférieure du transistor IGBT_{b1}, IGBT_{b2} sur une face supérieure du transistor IGBTₕ₁, IGBTₕ₂, respectivement.

Des connexions électriques sont ensuite réalisées par soudure de fils conducteurs BW qui relient des pastilles de connexion électrique des transistors à des parties correspondantes de la grille de connexion LF.

On notera, comme cela apparaît à la Fig.4, que le transistor IGBT_{b1}, IGBFb2 ne recouvre que partiellement le transistor IGBTₕ₁, IGBFh2, respectivement. Cette caractéristique autorise, d'une part, des connexions électriques par fils BW sur la face supérieure apparente du transistor IGBTₕ₁, IGBTₕ₂ et, d'autre part, une meilleure évacuation thermique.

L'utilisation d'une grille de connexion LF est une solution bien adaptée en microélectronique de puissance pour permettre le passage d'un courant important. Cependant, dans certaines applications de l'invention, il sera possible de s'en passer, au moins partiellement, et de souder directement les fils conducteurs BW sur des pastilles en cuivre de la carte PCB, notamment lorsque les contraintes d'encombrement sont relâchées et que les pistes en cuivre peuvent prendre une largeur suffisante pour le passage de forts courants.

L'empilage de puces réalisé conformément à l'invention satisfait aux contraintes thermiques importantes auxquelles l'électronique de puissance est soumise dans l'environnement d'un dispositif d'éclairage et/ou signalisation tel qu'un projecteur. Il est ainsi possible d'obtenir une électronique de puissance ayant un niveau élevé d'intégration et fonctionnant dans un environnement dont la température peut dépasser les 150°C.

On notera que le résultat ci-dessus est obtenu grâce à l'empilage de puces réalisé conformément à l'invention et à la combinaison entre eux des différents moyens et techniques décrits en référence aux Figs.3 et 4 qui autorisent une maîtrise de la résistance thermique globale entre les puces des transistors de puissance et le drain thermique 115.

On notera également que l'invention ne se limite pas à l'empilage de deux transistors de puissance, des empilages plus importants pouvant être réalisés sans pour autant sortir du cadre de l'invention. Ainsi, par exemple, dans une variante de réalisation, le module de commande 112 (Fig1) est implanté dans une puce de circuit de commande qui est empilée avec les transistors IGBT_{b1}, IGBTₕ₁ ou IGBT_{b2}, IGBTₕ₂.

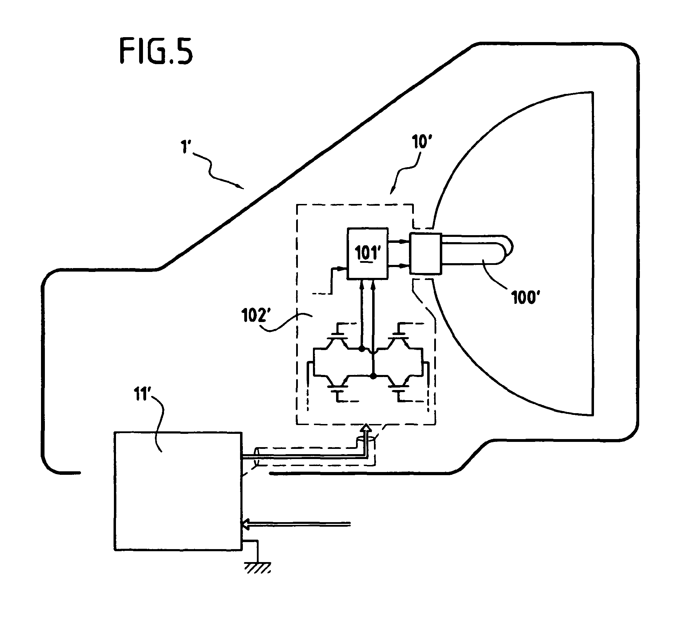

En référence à la Fig.5, il est maintenant décrit brièvement une seconde forme de réalisation particulière, désignée globalement 1', d'un projecteur selon l'invention.

Dans le projecteur 1', le pont de commutation haute tension formé par les transistors IGBT_{b1}, IGBTₕ₁ et IGBT_{b2}, IGBTₕ₂ est intégré dans un module électronique 102' associé à la lampe à décharge 100'. Le module électronique 102' comprend donc le module d'amorçage HT 101' et le pont de commutation IGBT_{b1}, IGBTₕ₁ et IGBT_{b2}, IGBTₕ₂.

Cette seconde forme de réalisation utilise donc une source de lumière 10' incorporant, sous la forme du module 102', une électronique ayant un niveau d'intégration supérieur à celui de la source de lumière 10 de la Fig.1. Ce niveau d'intégration supérieur est obtenu, conformément à l'invention, grâce à l'utilisation de la technique d'empilage de puces décrite plus haut en référence aux Figs.3 et 4. Avantageusement, dans cette forme de réalisation, un même substrat SUB est utilisé pour le module d'amorçage HT et le pont de commutation IGBT_{b1}, IGBTₕ₁ et IGBT_{b2}, IGBTₕ₂.

Bien entendu, dans cette seconde forme de réalisation, le ballast 11' du projecteur 1' présente une compacité accrue compte tenu de l'implantation du pont de commutation IGBT_{b1}, IGBTₕ₁ et IGBT_{b2}, IGBTₕ₂ dans la source de lumière 10'.

La présente invention ne se limite pas aux détails des formes de réalisation décrites ici à titre d'exemple, mais s'étend au contraire aux modifications à la portée de l'homme du métier, la portée de l'invention étant définie par les revendications annexées. Ainsi, par exemple, tout en restant dans la portée de l'invention, l'homme du métier pourra dans certaines applications utiliser des techniques d'encapsulation telles qu'une technique faisant appel à un gel de silicone ou autres. Ces techniques d'encapsulation peuvent en effet s'avérer avantageuses notamment pour accroître la compacité des modules électroniques tels que le module 102' de la source de lumière 10'.

## Revendications

1. Dispositif d'éclairage et/ou signalisation pour véhicule automobile comprenant une source de lumière (10, 10') et des moyens électroniques d'alimentation et de commande (11, 11' ; 101, 101'), les moyens électroniques comprenant au moins un circuit comportant au moins deux composants (IGBT_{b1}, IGBTₕ₁; IGBT_{b2}, IGBTₕ₂) de puissance, **caractérisé en ce que** les composants (IGBT_{b1}, IGBTₕ₁; IGBT_{b2}, IGBTₕ₂) de puissance sont formés dans un empilage de puces, **en ce que** une face inférieure d'un composant de puissance (IGBT_{b1}, IGBT_{b2}) est fixée (118) sur une face supérieure d'un autre composant de puissance (IGBTₕ₁, IGBTₕ₂), **et en ce que** le circuit comprend un substrat (SUB) de type circuit imprimé haute température, de type capton, de type céramique ou de type grille de connexion.

2. Dispositif selon la revendication 1, **caractérisé en ce** ladite source de lumière (10, 10') comporte une lampe; à décharge (100, 100') et ledit circuit est un convertisseur de type continu-alternatif (111) alimentant ladite lampe à décharge (100, 100').

3. Dispositif selon la revendication 2, **caractérisé en ce que** ladite lampe à décharge (100, 100') est de type xénon.

4. Dispositif selon la revendication 2 ou 3, **caractérisé en ce que** ledit circuit est compris dans un ballast électronique (111) dudit dispositif.

5. Dispositif selon la revendication 2 ou 3, **caractérisé en ce que** ledit circuit est compris dans un module électronique (101') associé à ladite lampe à décharge (100') et formant avec celle-ci un ensemble compact.

6. Dispositif selon l'une quelconque des revendications 2 à 5, **caractérisé en ce que** ledit circuit comporte un pont de commutation (111) à quatre transistors (IGBT_{b1}, IGBTₕ₁; IGBT_{b2}, IGBTₕ₂) et deux empilages de puces formés chacun avec deux transistors d'une même branche dudit pont de commutation.

7. Dispositif selon la revendication 6, **caractérisé en ce que** lesdits transistors sont de type IGBT ou MOS.

8. Dispositif selon la revendication 7, **caractérisé en ce que** ledit substrat comprend au moins un via thermique (114) au niveau d'au moins un dit empilage de puces (IGBT_{b1}, IGBTₕ₁; IGBT_{b2}, IGBTₕ₂).

9. Dispositif selon la revendication 8, **caractérisé en ce que** ledit circuit comprend également un drain thermique (115) contre lequel vient en contact thermique une face dudit substrat.

10. Dispositif selon la revendication 9, **caractérisé en ce que** ledit drain thermique est formé par un boîtier (115) contenant ledit circuit.

11. Dispositif selon la revendication 9 ou 10, **caractérisé en ce que** ladite face dudit substrat (SUB) et ledit drain thermique (115) sont fixés ensemble au moyen d'un adhésif (116) et/ou d'une feuille de préimprégné.

12. Dispositif selon l'une quelconque des revendications 1 à 11, **caractérisé en ce que** ledit circuit comprend également des moyens de connexion électrique comportant une grille de connexion (LF) et/ou des fils conducteurs soudés (BW).

13. Dispositif selon l'une quelconque des revendications 1 à 12, **caractérisé en ce que** au moins un dit empilage de puces comprend également une puce de circuit de commande (110, 112) empilée avec lesdits composants de puissance.

14. Système d'éclairage et/ou signalisation pour véhicule automobile, **caractérisé en ce que** il comprend au moins deux dispositifs d'éclairage et/ou signalisation (1) selon l'une au moins des revendications précédentes.

15. Source de lumière apte à être montée dans un dispositif d'éclairage et/ou signalisation selon l'une quelconque des revendications 1 à 13, comprenant une lampe (100') et un module électronique (102') associé à ladite lampe, **caractérisée en ce que** ledit module électronique comprend au moins un circuit comportant au moins un empilage de puces formé d'au moins deux composants de puissance (IGBT_{b1}, IGBTₕ₁; IGBT_{b2}, IGBTₕ₂), et **en ce que** le circuit comprend un substrat (SUB) de type circuit imprimé haute température, de type capton, de type céramique ou de type grille de connexion.

16. Véhicule automobile **caractérisé en ce qu'**il comprend au moins un dispositif d'éclairage et/ou signalisation (1, 1') selon l'une quelconque des revendications 1 à 13.

17. Véhicule automobile **caractérisé en ce qu'**il comprend au moins une source de lumière (10') selon la revendication 15.

## Claims

1. Lighting and/or signalling device for a motor vehicle comprising a light source (10, 10') and electronic supply and control means (11, 11'; 101, 101'), the electronic means comprising at least one circuit having at least two power components (IGBT_{b1}, IGBTₕ₁, IGBT_{b2}, IGBTₕ₂), **characterised in that** the power components (IGBT_{b1}, IGBTₕ₁, IGBT_{b2}, IGBTₕ₂) are formed in a stack of chips, **in that** a bottom face of a power component (IGBT_{b1}, IGBT_{b2},) is fixed (118) to a top face of another power component (IGBTₕ₁, IGBTₕ₂), and **in that** the circuit comprises a substrate (SUB) of the high-temperature printed circuit type, of the capton type, of the ceramic type or of the lead frame type.

2. Device according to claim 1, **characterised in that** the said light source (10, 10') comprises a discharge lamp (100, 100') and the said circuit is a converter of the DC to AC type (111) supplying the said discharge lamp (100, 100').

3. Device according to claim 2, **characterised in that** the discharge lamp (100, 100') is of the xenon type.

4. Device according to claim 2 or 3, **characterised in that** the said circuit is included in an electronic ballast (111) of the said device.

5. Device according to claim 2 or 3, **characterised in that** the said circuit is included in an electronic module (101') associated with the said discharge lamp (100') and forming with it a compact assembly.

6. Device according to any one of claims 2 to 5, **characterised in that** the said circuit comprises a switching bridge (111) with four transistors (IGBT_{b1}, IGBTₕ₁, IGBT_{b2}, IGBTₕ₂) and two stacks of chips each formed with two transistors of the same arm of the said switching bridge.

7. Device according to claim 6, **characterised in that** the said transistors are of the IGBT or MOS type.

8. Device according to claim 7, **characterised in that** the said substrate comprises at least one thermal via (114) at at least one said stack of chips (IGBT_{b1}, IGBTₕ₁, IGBT_{b2}, IGBTₕ₂).

9. Device according to claim 8, **characterised in that** the said circuit also comprises a thermal drain (115) against which one face of the said substrate comes into thermal contact.

10. Device according to claim 9, **characterised in that** the said thermal drain is formed by a housing (115) containing the said circuit.

11. Device according to claim 9 or 10, **characterised in that** the said face of the said substrate (SUB) and the said thermal drain (115) are fixed together by means of an adhesive (116) and/or a pre-impregnated sheet.

12. Device according to any one of claims 1 to 11, **characterised in that** the said circuit also comprises electrical connection means comprising a lead frame (LF) and/or soldered conductive wires (BW).

13. Device according to any one of claims 1 to 12, **characterise in that** at least one said stack of chips also comprises a control circuit chip (110, 112) stacked with the said power components.

14. Lighting and/or signalling system for a motor vehicle, **characterised in that** it comprises at least two lighting and/or signalling devices (1) according to at least one of the preceding claims.

15. Light source able to be mounted in a lighting and/or signalling device according to any one of claims 1 to 13, comprising a lamp (100') and an electronic module (102') associated with the said lamp, **characterised in that** the said electronic module comprises at least one circuit having at least one stack of chips formed from at least two power components (IGBT_{b1}, IGBTₕ₁, IGBT_{b2}, IGBTₕ₂), and **in that** the circuit comprises a substrate (SUB) of the high-temperature printed circuit type, of the capton type, of the ceramic type or of the lead frame type.

16. Motor vehicle, **characterised in that** it comprises at least one lighting and/or signalling device (1, 1') according to any one of claims 1 to 13.

17. Motor vehicle, **characterised in that** it comprises at least one light source (10') according to claim 15.

## Patentansprüche

1. Beleuchtungs- und/oder Signalgebungsvorrichtung für Kraftfahrzeuge, mit einer Lichtquelle (10, 10') und elektronischen Stromversorgungs- und Steuermitteln (11, 11'; 101, 101'), wobei die elektronischen Mittel wenigstens einen Schaltkreis umfassen mit wenigstens zwei Leistungsbauelementen (IGBT_{b1}, IGBTₕ₁; IGBT_{b2}, IGBTₕ₂),
**dadurch gekennzeichnet, dass** die Leistungsbauelemente (IGBT_{b1}, IGBTₕ₁; IGBT_{b2}, IGBTₕ₂) in einem Chip-Stapel gebildet sind, dass eine Unterseite eines Leistungsbauelements (IGBT_{b1}, IGBT_{b2}) auf einer Oberseite eines anderen Leistungsbauelements (IGBTₕ₁, IGBTₕ₂) befestigt ist, und dass der Schaltkreis ein Trägersubstrat (SUB) vom Typ gedruckte Hochtemperaturschaltung, vom Typ Kapton, vom Typ Keramik oder vom Typ Leiterrahmen aufweist.

2. Vorrichtung nach Anspruch 1,
**dadurch gekennzeichnet, dass** die Lichtquelle (10, 10') eine Entladungslampe (100, 100') umfasst, und der Schaltkreis ein die Entladungslampe (100, 100') speisender Wandler vom Typ Gleichspannungs-Wechselspannungswandler (111) ist.

3. Vorrichtung nach Anspruch 2,
**dadurch gekennzeichnet, dass** die Entladungslampe (100, 100') vom Typ Xenon-Lampe ist.

4. Vorrichtung nach Anspruch 2 oder 3,
**dadurch gekennzeichnet, dass** der Schaltkreis in einem elektronischen Vorschaltgerät (111) der Vorrichtung enthalten ist.

5. Vorrichtung nach Anspruch 2 oder 3,
**dadurch gekennzeichnet, dass** der Schaltkreis in einem der Entladungslampe (100') zugeordneten Elektronikmodul (101') enthalten ist, das mit dieser eine kompakte Einheit bildet.

6. Vorrichtung nach einem der Ansprüche 2 bis 5,
**dadurch gekennzeichnet, dass** der Schaltkreis eine Kommutierungsbrücke (111) mit vier Transistoren (IGBT_{b1}, IGBTₕ₁; IGBT_{b2}, IGBTₕ₂) und zwei Chip-Stapeln umfasst, die jeweils mit zwei Transistoren ein und desselben Zweigs der Kommutierungsbrücke gebildet sind.

7. Vorrichtung nach Anspruch 6,
**dadurch gekennzeichnet, dass** die Transistoren vom Typ IGBT oder MOS sind.

8. Vorrichtung nach Anspruch 7,
**dadurch gekennzeichnet, dass** das Trägersubstrat wenigstens einen thermischen Pfad (114) in Höhe wenigstens eines Chip-Stapels (IGBT_{b1}, IGBTₕ₁; IGBT_{b2}, IGBTₕ₂) aufweist.

9. Vorrichtung nach Anspruch 8,
**dadurch gekennzeichnet, dass** der Schaltkreis auch eine Wärmesenke (115) aufweist, gegen die eine Seite des Trägersubstrats in thermischen Kontakt gelangt.

10. Vorrichtung nach Anspruch 9,
**dadurch gekennzeichnet, dass** die Wärmesenke durch ein Gehäuse (115) gebildet ist, das den Schaltkreis enthält.

11. Vorrichtung nach Anspruch 9 oder 10,
**dadurch gekennzeichnet, dass** die Seite des Trägersubstrats (SUB) und die Wärmesenke (115) mittels eines Klebstoffs (116) und/oder eines Prepregs aneinander befestigt sind.

12. Vorrichtung nach einem der Ansprüche 1 bis 11,
**dadurch gekennzeichnet, dass** der Schaltkreis auch elektrische Anschlussmittel mit einem Leiterrahmen (LF) und/oder Bonddrähten (BW) umfasst.

13. Vorrichtung nach einem der Ansprüche 1 bis 12,
**dadurch gekennzeichnet, dass** wenigstens ein Chip-Stapel auch einen Kommutierungskreis-Chip (110, 112) umfasst, der mit den Leistungsbauelementen gestapelt ist.

14. Beleuchtungs- und/oder Signalgebungssystem für Kraftfahrzeuge,
**dadurch gekennzeichnet, dass** es wenigstens zwei Beleuchtungs- und/oder Signalgebungsvorrichtungen (1) nach wenigstens einem der vorhergehenden Ansprüche umfasst.

15. Lichtquelle, die in einer Beleuchtungs- und/oder Signalgebungsvorrichtung nach einem der Ansprüche 1 bis 13 montiert zu werden vermag, mit einer Lampe (100') und einem der Lampe zugeordneten Elektronikmodul (102'),
**dadurch gekennzeichnet, dass** das Elektronikmodul wenigstens einen Schaltkreis mit wenigstens einem Chip-Stapel umfasst, der von wenigstens zwei Leistungsbauelementen (IGBT_{b1}, IGBTₕ₁; IBGT_{b2}, IGBTₕ₂) gebildet ist, und dass der Schaltkreis ein Trägersubstrat (SUB) vom Typ gedruckte Hochtemperaturschaltung, vom Typ Kapton, vom Typ Keramik oder vom Typ Leiterrahmen aufweist.

16. Kraftfahrzeug,
**dadurch gekennzeichnet, dass** es wenigstens eine Beleuchtungs- und/oder Signalgebungsvorrichtung (1, 1') nach einem der Ansprüche 1 bis 13 umfasst.

17. Kraftfahrzeug,
**dadurch gekennzeichnet, dass** es wenigstens eine Lichtquelle (10') nach Anspruch 15 umfasst.
